(19) Europäisches Patentamt / European Patent Office / Office européen des brevets

(11) **EP 3 712 626 B1**

(12) **EUROPEAN PATENT SPECIFICATION**

(45) Date of publication and mention
of the grant of the patent:
**13.09.2023   Bulletin 2023/37**

(21) Application number: **19163779.2**

(22) Date of filing: **19.03.2019**

(51) International Patent Classification (IPC):
**G01R 23/20** (2006.01)    **H04L 1/00** (2006.01)
**H04L 27/26** (2006.01)

(52) Cooperative Patent Classification (CPC):
**H04L 27/2636; G01R 23/20**

(54) **HIGH-RATE DFT-BASED DATA MANIPULATOR AND DATA MANIPULATION METHOD FOR HIGH PERFORMANCE AND ROBUST SIGNAL PROCESSING**

DATENMANIPULATOR AUF BASIS VON HOCHRATIGER DFT UND DATENMANIPULATIONSVERFAHREN FÜR EINE LEISTUNGSSTARKE UND ROBUSTE SIGNALVERARBEITUNG

MANIPULATEUR DE DONNÉES HAUT DÉBIT BASÉES SUR DFT ET PROCÉDÉ DE MANIPULATION DE DONNÉES POUR UN TRAITEMENT DE SIGNAL ROBUSTE ET HAUTE PERFORMANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.09.2020   Bulletin 2020/39**

(73) Proprietor: **Fraunhofer-Gesellschaft zur Förderung
der angewandten Forschung e.V.
80686 München (DE)**

(72) Inventors:
• **VAN DER MERWE, Johannes Rossouw
91058 Erlangen (DE)**
• **RÜGAMER, Alexander
91058 Erlangen (DE)**
• **GARZIA, Fabio
91058 Erlangen (DE)**

(74) Representative: **Schairer, Oliver Michael et al
Schoppe, Zimmermann, Stöckeler
Zinkler, Schenk & Partner mbB
Patentanwälte
Radlkoferstraße 2
81373 München (DE)**

(56) References cited:
**US-A- 5 410 750       US-A- 6 097 820
US-A1- 2007 202 829   US-A1- 2018 013 514**

**Description**

The present invention relates to a high-rate Discrete Fourier Transform (DFT)-based data manipulator and to data manipulation method for high performance and robust signal processing.

High-rate DFT-Based Data Manipulator (HDDM) for high performance and robust signal processing

The electromagnetic spectrum is an open resource which can be used by anyone; hence unwanted signals can be transmitted if the adequate equipment is available. Interference signals, whether intentional or unintentional, can disrupt received electromagnetic signals. This can result in a system to lose operation. Moreover, propagation effects of the environment can severely alter the signal, causing the spectrum to deform.

There are a number of methods to suppress interferences. In most cases these methods attempt to remove the interference signal, whilst trying to recover as much as possible form the signal of interest. A common strategy is to find a signal-space where the interference is sparse. Such a strategy includes the use of time domain pulse blanking for short burst-like interferences; filtering for frequency selective interferences; or an array of antennas with beam- and/or null-steering for interference in the spatial domain. As an array of antennas is an expensive increase in system components and complexity, it is often not financially and spatially feasible for use for most applications, hence these solutions are omitted for the remainder of the document.

Many intentional interferers, referred to as jammers, try to overcome this limitation by creating signals which are dynamic. These signals move in the signal space and cannot be removed as easily. Examples of such signals are Frequency Modulated Continuous Wave (FMCW) signals, also referred to as "chirps". If block transformations of the signal space (i.e. in time or in frequency domain) are used, then the interference is smeared by the dynamic behavior of the interference, making it difficult to separate from the signal of interest. This is a limitation of methods such as Frequency Domain Adaptive Filtering (FDAF), since much of the signal of interest is also removed. Adaptive Systems attempt to estimate and predict the behavior of the interference and remove it accordingly; however, this is limited by the dynamics of the interference and the correcting ability of the algorithm. In FDAF, only a single block of data is used to calculate the Fast Fourier Transform (FFT). On the other hand, discrete Wavelet transform filter down-sample the signal, and therefore loses time accuracy after each stage, but gains frequency accuracy.

Transform-based methods (like FDAF, wavelet transforms or poly-phase filter banks), are limited by the time-frequency trade-off of the signals: a high resolution in the time domain leads to low frequency domain resolution and vice versa. Further, the inclusion of blanking methods, such as pulse blankers (PBs), creates discontinuities in the signal. These discontinuities create unwanted effects and distortions, which are amplified when done in other domains, and transformed back. These effects are often not accounted for in algorithms. Therefore, transform based algorithms can heavily distort a signals upon reconstruction and are limited by the transform size (time-frequency trade-off).

Further, adaptive algorithms have the possibility to become instable, resulting in complete disruption of the system. This is evident with the performance limitations of Adaptive Notch Filters (ANFs).

Other concepts of the prior art relate to a poly-phase filter bank which down-samples the signal, thereby reducing time accuracy. Further, the filter design should be done with good accuracy, as any overlap of filters or gaps between filters can heavily distort the complete system throughput. This additional filter design should be optimized, and a number of trade-offs exists which increases the design thereof.

Spectral deformation as caused by multipath and fading effects can influence the quality of the received signal. The filter transfer function can also lead to signal distortion, e.g. by group delay variations. In GNSS, these distortions can lead to false peak locks (especially with higher-order binary offset carrier modulated signals). Signal equalization and filtering may, e.g., be employed to address these issues.

ANF, Frequency Domain Adaptive Processing (FDAP), Kalman filter estimation and signal tracking try to estimate and predict the movement of the interferences. This adds additional complexity and uncertainty, and can lead to system to become unstable.

Running DFTs for spectral estimation apply concepts of computing a FFT for each time offset, and has been used for spectral estimation methods. However, the signal is not reconstructed by these concepts.

KR 2004 0048090 A discloses a peak value detecting method and apparatus for rejecting narrow-band interference to prevent degradation of performance caused by a narrow-band interference signal received in a receiving band. The provided concepts are only applicable to narrowband interferences, only the peak value is removed, and power is calculated over the FFT.

US 2002 051433 A discloses a receiver which addresses the need for improved interference suppression without the number of transmissions by the power control system being increased, and, to this end, provides a receiver for a CDMA communications system which employs interference subspace rejection to tune a substantially null response to interference components from selected signals of other user stations. It is only applicable for CDMA and uses the code subspace and power control.

US 2009 239472 A discloses an apparatus and a method for removing an interference in a multiple antenna system. The apparatus includes a channel estimator, a covariance matrix generator, a weight calculator, and a beam forming unit. The channel estimator estimates a channel for a service cell and an interference channel for an adjacent cell using sounding signals via a plurality of antennas.

US 2009 081980 A discloses an apparatus, systems, and methods for suppressing radio interference from a noise source. The apparatus includes a controller for commanding a noise source to dither its operating frequency, and a filter for receiving signals from the controller indicating the present operating frequency of the noise source and to filter radio signals having the same frequency as the present operating frequency while the operating frequency is dithered. FFT is not employed.

CN 1463104 A discloses interference elimination according to serial mode in the order determined by the likelihood ratio based on the output of combining maximum ratios. The user with the largest absolute value of likelihood ratio is detected first and the signal generator generates the interference signal of the user. With the said signal being removed from the output of the matched filter, the procedures of de-spread and combining maximum ratios are carried out again and the likelihood ratio is recalculated. The error code platform and the error code rate of the invention are low in small spread spectrum ratio N=4 and large ratio N=128 in CDMA system. The provided concepts are only applicable to CDMA, uses the code subspace and power control.

US 2006 195279 A discloses a method and a system for the detection and/or removal of sinusoidal interference signals in/from a noise signal transforms a measured signal composed of a limited number of sinusoidal interference signals and a white noise signal into a subspace containing its white noise components and a subspace containing its interference signal components. The provided concepts are limited to sinusoidal interferences. Uses an FET for estimation only, and not tor deconstruction and reconstruction of the signal. The filter bank does down sampling.

US 2003 140771 A discloses that when the inner product of signal eigenvalue vectors and azimuth vectors is transformed using an FFT and a MUSIC spectrum is calculated, the inner product of noise eigenvalue vectors and azimuth vectors is transformed using the FFT and a MUSIC spectrum is calculated. A DOA is then estimated based on the MUSIC spectrum obtained, thereby decreasing the quantity of calculations required for detecting a DOA of an incident wave using MUSIC algorithm. The disclosed method does not cancel interferences.

US 2002 094044 A discloses a filter settings generation operation which includes sampling a communication channel to produce a sampled signal. The sampled signal is spectrally characterized across a frequency band of interest to produce a spectral characterization of the sampled signal. This spectral characterization may not include a signal of interest. The spectral characterization is then modified to produce a modified spectral characterization. Filter settings are then generated based upon the modified spectral characterization. At first, the signal is characterized, then an applicable filter is created.

In US 2013 208838 A, techniques are provided which may be implemented using methods and/or apparatuses in a device comprising a receiver to scan a spectral band of a received signal comprising a desired signal contribution to determine whether signal data associated with at least a sub-band of the spectral band further comprises at least one undesired signal contribution. In response to determining that the signal data comprises at least one undesired signal contribution, the mobile station may initiate at least one notch filter to affect the undesired signal contribution in subsequent signal data associated with the received signal. A notch filter is implemented.

CN 102147429 A discloses a broadband microwave power meter and an interference signal filtering method. The power meter comprises an A/D conversion module, an FFT (fast Fourier transform) module, a power spectrum estimation module, a power spectrum integration module, an interference detection module and a digital filter module. FFT is used to estimate the spectrum and to generate a filter.

US 2012 321024 A discloses a method of canceling sinusoidal interference from a received signal includes identifying a block of signal-free data containing sinusoidal interference. A model of the significant interference in the selected data block is constructed, scaled to subsequent data blocks and used to remove sinusoidal interference signals from the overall received signal. The method is only applicable to a single sinusoidal frequency.

US 2006 029142 A discloses an improved ingress cancellation filter comprising a Fast Fourier Transform circuit which replaces the analysis filter bank of the prior art to break the incoming signal down into sub bands, an ingress cancellation filter that weights each sub band based upon the probability that the sub band is corrupted by noise, and an inverse Fast Fourier Transform circuit to put the weighted sub bands back together into an output signal.

US 6,097,820 A discloses a noise suppressor that increases a signal to noise ratio of time domain audio data and a method of increasing such signal to noise ratio. The noise suppressor includes a frequency domain transformation circuitry that transforms a frame of the time domain audio data into a frequency domain, a noise background modeling circuitry, coupled to the domain transformation circuitry, that spectrally analyzes the frame to model an estimated noise background spectrum thereof, a frequency domain suppression filter, coupled to the noise background modeling circuitry, that filters at least some of the noise background spectrum from the frame and a time domain transformation circuitry, coupled to the frequency domain suppression filter, that transforms the frame back into a time domain, the transformed frame having an increased signal to noise ratio.

The object of the present invention is to provide improved concepts for high performance and robust signal processing. The object of the present invention is solved by an apparatus according to claim 1, by a method according to claim 14 and by a computer program according to claim 15.

An apparatus for generating a reconstructed time-domain signal from an input time-domain signal is provided. The apparatus comprises a transformation unit, a manipulation unit, and a reconstruction unit. In a first clock cycle, the transformation unit is configured to transform a first plurality of time-domain samples of the input time-domain signal or derived from the input time-domain signal from a time domain to a frequency domain to obtain a first plurality of frequency-domain samples of a frequency-domain signal. In a second clock cycle, the transformation unit is configured to transform a second plurality of the time-domain samples of the input time-domain signal or derived from the input time-domain signal from the time domain to the frequency domain to obtain a second plurality of frequency-domain samples of the frequency-domain signal. The first plurality of time-domain samples and the second plurality of time-domain samples comprise one or more same time-domain samples of the input time-domain signal. The manipulation unit is configured to manipulate one or more frequency-domain samples of the first plurality of frequency-domain samples to obtain a first plurality of manipulated frequency samples, and wherein manipulation unit is configured to manipulate one or more frequency-domain samples of the second plurality of frequency-domain samples to obtain a second plurality of manipulated frequency samples. The reconstruction unit is configured to generate the reconstructed time-domain signal depending on the first plurality of manipulated frequency samples and depending on the second plurality of manipulated frequency samples.

Moreover, a method for generating a reconstructed time-domain signal from an input time-domain signal is provided. The method comprises:

- Transforming, in a first clock cycle, a first plurality of time-domain samples of the input time-domain signal or derived from the input time-domain signal from a time domain to a frequency domain to obtain a first plurality of frequency-domain samples of a frequency-domain signal.
- Transforming, in a second clock cycle, a second plurality of the time-domain samples of the input time-domain signal or derived from the input time-domain signal from the time domain to the frequency domain to obtain a second plurality of frequency-domain samples of the frequency-domain signal, wherein the first plurality of time-domain samples and the second plurality of time-domain samples comprise one or more same time-domain samples of the input time-domain signal.
- Manipulating one or more frequency-domain samples of the first plurality of frequency-domain samples to obtain a first plurality of manipulated frequency samples, and manipulating one or more frequency-domain samples of the second plurality of frequency-domain samples to obtain a second plurality of manipulated frequency samples. And:
- Generating the reconstructed time-domain signal depending on the first plurality of manipulated frequency samples and depending on the second plurality of manipulated frequency samples.

Furthermore, a computer program for implementing the above-described method when being executed on a computer or signal processor is provided.

In the following, embodiments of the present invention are described in more detail with reference to the figures, in which:

Fig. 1    illustrates an apparatus for interference reduction in an input time-domain signal to obtain a reconstructed time-domain signal according to an embodiment.

Fig. 2    illustrates a High-rate DFT-Based data manipulator according to an embodiment.

Fig. 3    illustrates an example spectrum of a Discrete Fourier Transform of N=32 size using a Hamming window according to an embodiment.

Fig. 4    illustrates an example implementation of the High-rate DFT-Based data manipulator for interference management, for N = 8 and using pulse blankers according to an embodiment.

Fig. 5    illustrates the spectrum for the eight channels of Fig. 4 according to an embodiment.

Fig. 6    illustrates spectrogram examples for Pulse blanker based mitigation against a chirp interference according to an embodiment.

Fig. 7    illustrates a reconstruction of eight channels for a system using a Hamming window according to an embodiment.

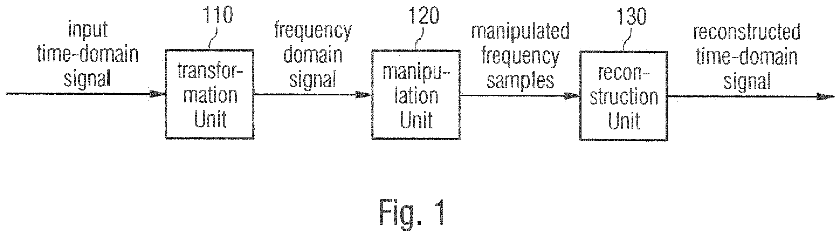

Fig. 1 illustrates an apparatus for generating a reconstructed time-domain signal from an input time-domain signal according to an embodiment. The apparatus comprises a transformation unit 110, a manipulation unit 120, and a reconstruction unit 130.

In a first clock cycle, the transformation unit 110 is configured to transform a first plurality of time-domain samples of the input time-domain signal or derived from the input time-domain signal from a time domain to a frequency domain to obtain a first plurality of frequency-domain samples of a frequency-domain signal.

In a second clock cycle, the transformation unit 110 is configured to transform a second plurality of the time-domain samples of the input time-domain signal or derived from the input time-domain signal from the time domain to the frequency domain to obtain a second plurality of frequency-domain samples of the frequency-domain signal. The first plurality of time-domain samples and the second plurality of time-domain samples comprise one or more same time-domain samples of the input time-domain signal.

The manipulation unit 120 is configured to manipulate one or more frequency-domain samples of the first plurality of frequency-domain samples to obtain a first plurality of manipulated frequency samples, and wherein manipulation stage is configured to manipulate one or more frequency-domain samples of the second plurality of frequency-domain samples to obtain a second plurality of manipulated frequency samples.

The reconstruction unit 130 is configured to generate the reconstructed time-domain signal depending on the first plurality of manipulated frequency samples and depending on the second plurality of manipulated frequency samples.

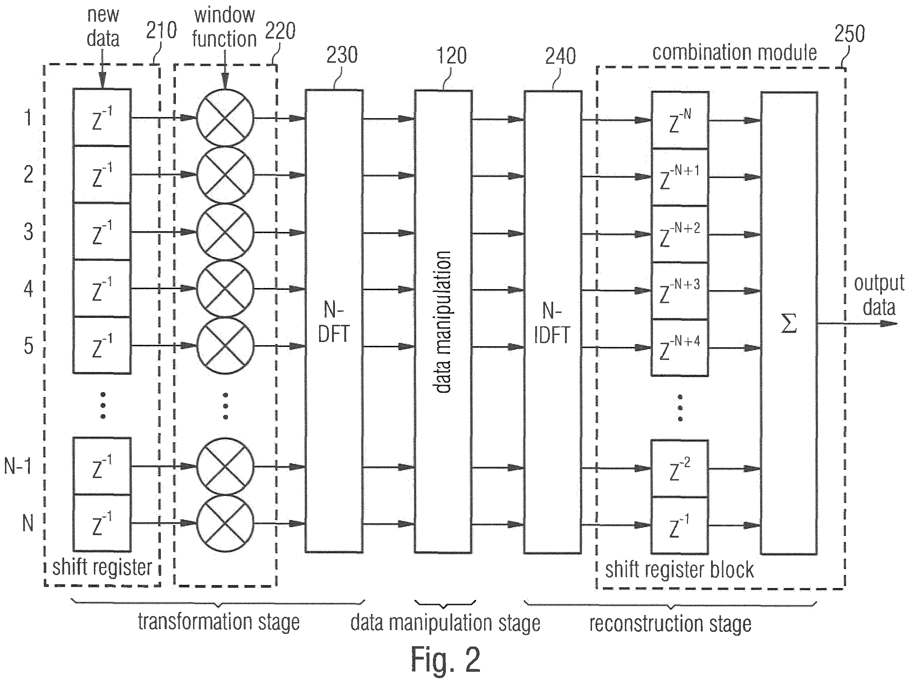

In an embodiment (see Fig. 2), the transformation unit 110 may, e.g., comprise a shift register 210 and a transform module 230. The shift register 210 may, e.g., comprise plurality of storage elements, wherein the transformation module may, e.g., be configured to store the first plurality of the time-domain samples within the plurality of storage elements of the shift register 210. In the first clock cycle, the transform module 230 may, e.g., be configured to transform the first plurality of the time-domain samples from the time domain to the frequency domain to obtain the first plurality of the frequency-domain samples. After transforming the first plurality of time-domain samples by the transform module 230, the shift register 210 may, e.g., be configured to shift each of the first plurality of time-domain samples in the shift register 210, so that one the first plurality of time-domain samples is moved out of the shift register 210, so that each other of the first plurality of time-domain samples is moved from its storage element to a neighbouring storage element, and so that another time-domain sample of the input time-domain signal or derived from the input time-domain signal, not comprised by the first plurality of time-domain samples, is stored in the storage element, wherein the time-domain samples being stored in the storage element after shifting form the second plurality of the time-domain samples. In the second clock cycle, the transform module 230 may, e.g., be configured to transform the second plurality of the time-domain samples from the time domain to the frequency domain to obtain the second plurality of the frequency-domain samples of the frequency-domain signal.

According to an embodiment, the transformation unit 110 may, e.g., comprise a window module 220. Before transforming the first plurality of time-domain samples derived from the input time-domain signal, the window module 220 may, e.g., be configured to apply a windowing function on the first plurality of time-domain samples of the input time-domain signal to obtain the first plurality of time-domain samples derived from the input time-domain signal. Before transforming the second plurality of time-domain samples derived from the input time-domain signal, the window module 220 may, e.g., be configured to apply the windowing function on the second plurality of time-domain samples of the input time-domain signal to obtain the second plurality of time-domain samples derived from the input time-domain signal.

In an embodiment, the windowing module may, e.g., be configured to apply the windowing function on the first plurality of time-domain samples of the input time-domain signal, so that a Hamming Window is applied on the first plurality of time-domain samples of the input time-domain signal. The windowing module may, e.g., be configured to apply the windowing function on the second plurality of time-domain samples of the input time-domain signal, so that the Hamming Window is applied on the second plurality of time-domain samples of the input time-domain signal.

According to an embodiment, the windowing module may, e.g., be configured to apply the windowing function on the first plurality of time-domain samples of the input time-domain signal, so that a Hann Window is applied on the first plurality of time-domain samples of the input time-domain signal. The windowing module may, e.g., be configured to apply the windowing function on the second plurality of time-domain samples of the input time-domain signal, so that the Hann Window is applied on the second plurality of time-domain samples of the input time-domain signal.

In other embodiments, other kind of windows are applied on the first plurality of samples and on the second plurality of samples, for example, a Balckmann-Harris window, or a Chebychev window, or a Kaiser-Bessel window, etc.

In an embodiment" in the first clock cycle, the transformation unit 110 may, e.g., be configured to transform the first plurality of time-domain samples of the input time-domain signal or derived from the input time-domain signal from the time domain to the frequency domain by conducting a Discrete Fourier Transform or by conducting a Fast Fourier Transform. In the second clock cycle, the transformation unit 110 may, e.g., be configured to transform the second plurality of time-domain samples of the input time-domain signal or derived from the input time-domain signal from the time domain to the frequency domain by conducting the Discrete Fourier Transform or by conducting the Fast Fourier Transform.

According to an embodiment, the manipulation unit 120 may, e.g., be configured to remove the one or more frequency-domain samples of the first plurality of frequency-domain samples from the first plurality of frequency-domain samples to obtain the first plurality of manipulated frequency samples, and wherein manipulation stage is configured to remove the one or more frequency-domain samples of the second plurality of frequency-domain samples from the second plurality of frequency-domain samples to obtain the second plurality of manipulated frequency samples.

In an embodiment, the manipulation unit 120 may, e.g., be configured to manipulate the first plurality of frequency-domain samples by filtering the first plurality of frequency-domain samples to obtain the first plurality of manipulated frequency samples. The manipulation unit 120 may, e.g., be configured to manipulate the second plurality of frequency-domain samples by filtering the second plurality of frequency-domain samples to obtain the first plurality of manipulated frequency samples.

According to an embodiment, the manipulation unit 120 may, e.g., be configured to manipulate the first plurality of frequency-domain samples by spectrum shaping the first plurality of frequency-domain samples to obtain the first plurality of manipulated frequency samples. The manipulation unit 120 may, e.g., be configured to manipulate the second plurality of frequency-domain samples by spectrum shaping the second plurality of frequency-domain samples to obtain the first plurality of manipulated frequency samples.

In an embodiment, the reconstruction unit 130 may, e.g., comprise an inverse transform module 240 and a combination module 250. The inverse transform module 240 may, e.g., be configured to transform the first plurality of manipulated frequency samples from the frequency domain to the time domain to obtain a first plurality of manipulated time samples. Moreover, the inverse transform module 240 may, e.g., be configured to transform second plurality of manipulated frequency samples from the frequency domain to the time domain to obtain a second plurality of manipulated time samples. The combination module 250 may, e.g., be configured to combine the first plurality of manipulated time samples and the second plurality of manipulated time samples to obtain a plurality of time-domain samples of the reconstructed time-domain signal.

According to an embodiment, the inverse transform module 240 may, e.g., be configured to transform the first plurality of manipulated frequency samples from the frequency domain to the time domain by conducting an Inverse Discrete Fourier Transform or by conducting an Inverse Fast Fourier Transform. Moreover, the inverse transform module 240 may, e.g., be configured to transform the second plurality of manipulated frequency samples from the frequency domain to the time domain by conducting the Inverse Discrete Fourier Transform or by conducting the Inverse Fast Fourier Transform.

In an embodiment, the combination module 250 may, e.g., be configured to apply a triangular delay on the first plurality of manipulated time samples and to apply a triangular delay on the second plurality of manipulated time samples and to combine the first plurality of manipulated time samples and the second plurality of manipulated time samples to obtain the plurality of time-domain samples of the reconstructed time-domain signal.

According to an embodiment, the combination module 250 may, e.g., be configured to scale the first plurality of manipulated time samples to obtain a first plurality of scaled time samples. Moreover, the combination module 250 may, e.g., be configured to scale the second plurality of manipulated time samples to obtain a second plurality of scaled time samples. Furthermore, the combination module 250 may, e.g., be configured to add the first plurality of scaled time samples and the second plurality of scaled time samples to obtain the plurality of time-domain samples of the reconstructed time-domain signal.

Embodiments are based on the finding that to retain operation, a receiver should mitigate interferences as well as possible.

In embodiments, the High-rate DFT-Based data manipulator (HDDM) applies continuous concepts which focus on adding redundancy to limit distortions.

Moreover, in embodiments, the HDDM has no limitation when it comes to windowing. The HDDM does not down-sample; hence better time accuracy is achievable.

Furthermore, according to embodiments the HDDM uses a single simple pulse blankers (PB), hence it is robust and requires no feedback loops are needed to constantly adjust the system. The HDDM reconstructs the signal using the triangular delay line. In embodiments, application may, e.g., be conducted block wise.

According to embodiments, the High-rate DFT-Based data manipulator (HDDM) works similar as other frequency domain concepts. However, instead of focusing on minimal transformation required for information transfer (such as polyphaser filtering or wavelet based transforms), a Discrete Fourier Transform (DFT) over each time offset, may, e.g., be calculated. This results in an implicit oversampling of the DFT spectrum, and therefore signal redundancy is created. This added redundancy allows the advanced temporal processing, such as suppression interferences, filtering or spectral equalization. For example, adding a PB for each DFT channel with the added signal redundancy reduces maleficent effects, such as ringing or discrete phase distortions; this is in contrast to what is observed in the FDAF algorithm.

When reconstructing the signal, the redundancy allows a larger portion of the signal of interest to be extracted.

In the following, the transformation stage is considered.

The architecture of the HDDM is shown in Fig. 2. In particular, Fig. 2 illustrates a block diagram of the FFT-PB according to an embodiment.

The HDDM stores each new data-point of the input signal in a shift register 210 running with the System's sampling clock. Each delay of the shift register 210 splits the signal into N separate channels, these channel will be referred to for the remainder of the processing. The whole shift register 210 is then multiplied with a windowing function, either explicitly with a desired window (Hamming window, Hann window, etc.), or implicitly (when no multiplication is done, resulting in a rectangular window). The windowing function shapes the filter for each frequency channel. The windowed signal is then used to calculate a DFT. This is done for each new data-point, i.e. a DFT is calculated on each clock cycle, hence each frequency channel has the same sample rate as the original signal; this is as opposed to the sample-rate reduction of factor N as what is used for block-wise processing. The window and the DFT form the transformation stage of the processing.

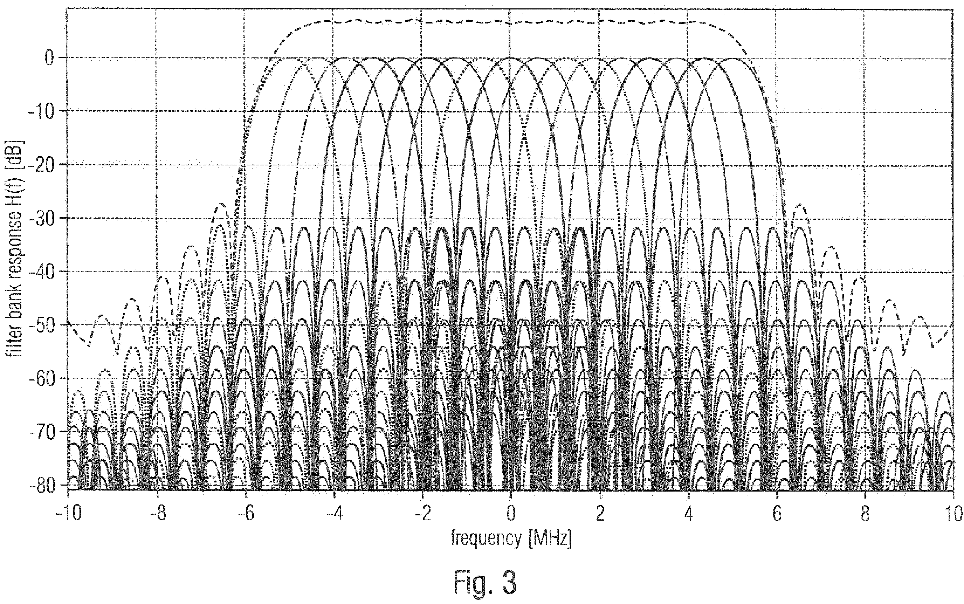

As an example, the equivalent spectrum of a DFT of size N = 32, for a signal sampled at a rate of 20 MHz is shown in Fig. 3.

Fig. 3 illustrates an example spectrum of a DFT of N=32 size using a Hamming window according to an embodiment. In the embodiment of Fig. 3, a Hamming window is used and only the central 17 frequency channels are shown. (The outer channels are nulled for clarity of concept).

Now, the data manipulation stage is considered.

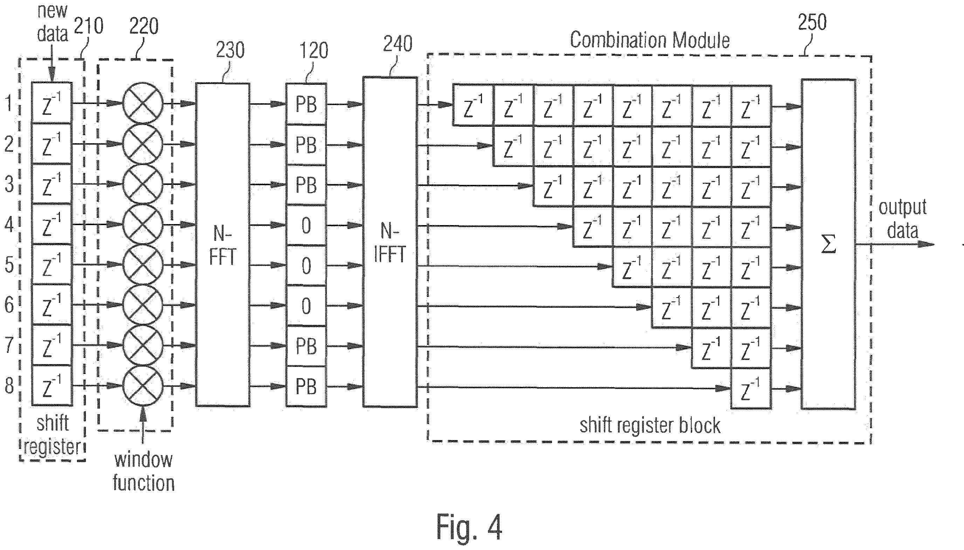

Each frequency channel is then passed through a data manipulator. In the case of interference mitigation this can be a simple PB to remove unwanted sections of the spectrum, or more complex functions such as limiting functions of non-linear compressing functions. The spectrum can also be altered, for example, nulling of a spectrum (e.g., full channel blanking), equalization (spectrum shaping) of the spectrum or filtering of the spectrum. An example implementation using PB for 5 channels to mitigate interferences, and direct nulling of 3 channels to shape the spectrum is shown in Fig. 4.

Fig. 4 illustrates an example implementation of the HDDM for interference management, for N = 8 and using PBs according to an embodiment.

In this example the more efficient implementation of the DFT, known as the fast Fourier Transform (FFT) is used for N=8 (the FFT is mathematically the same as the DFT, it only requires fewer multiplications when implemented).

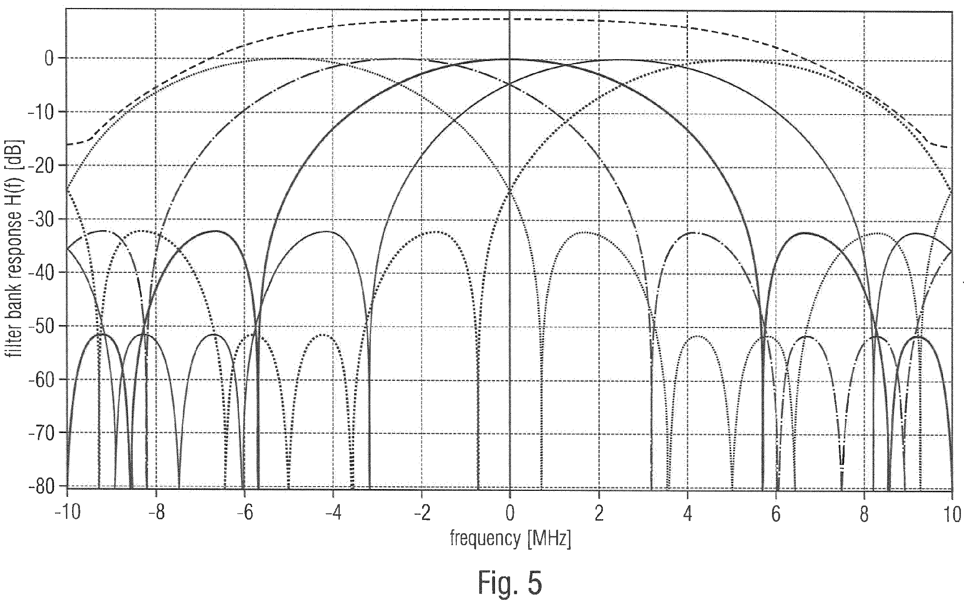

Fig. 5 illustrates the spectrum for the eight channels of Fig. 4 according to an embodiment. In particular, Fig. 5 illustrates an example spectrum for N=8, and a system with spectral shaping according to an embodiment. The each channel's response is shown by a different color, and the combined spectrum is shown by the black dotted line.

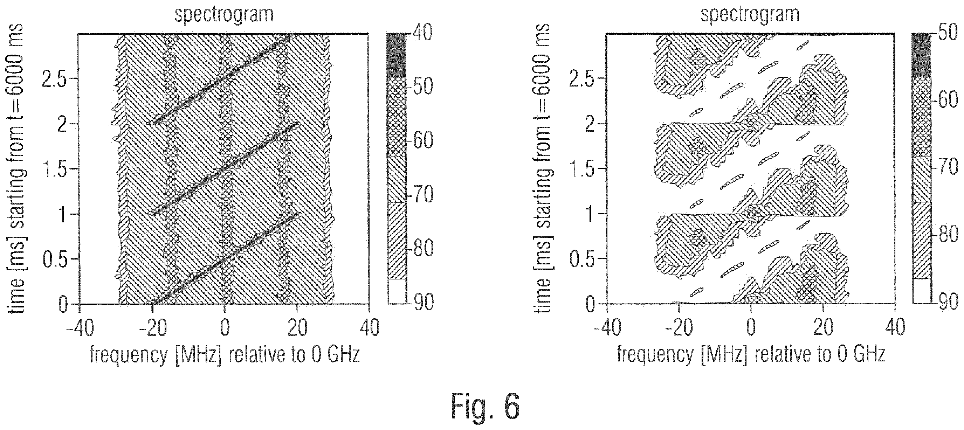

Fig. 6 illustrates an example spectrogram of the output of an 8-Channel implementation, but at a different sample rate, against a chirp signal according to an embodiment. In particular, Fig. 6 illustrates an example spectrogram for PB based mitigation against a chirp interference according to an embodiment.

The input signal is shown left, and the output signal is shown right.

In the following, the reconstruction stage is considered.

After mitigation and shaping, the signal is then passed through an Inverse-DFT (IDFT) to take each channel back to the time domain. Now there are N-channels, which should be combined again. As each signal is a time delayed signal, a triangular delay matrix is required: the first value is delayed by N-stages, and the last one by 1. This triangular delay lines is the largest contribution of the method: to combine the results efficiently. The signals are then combined to a single value. This combination of the signals results in a reduction of the redundancy, created by the initial shift register 210. These last stages form part of the inverse-transform, or the reconstruction of the signal.

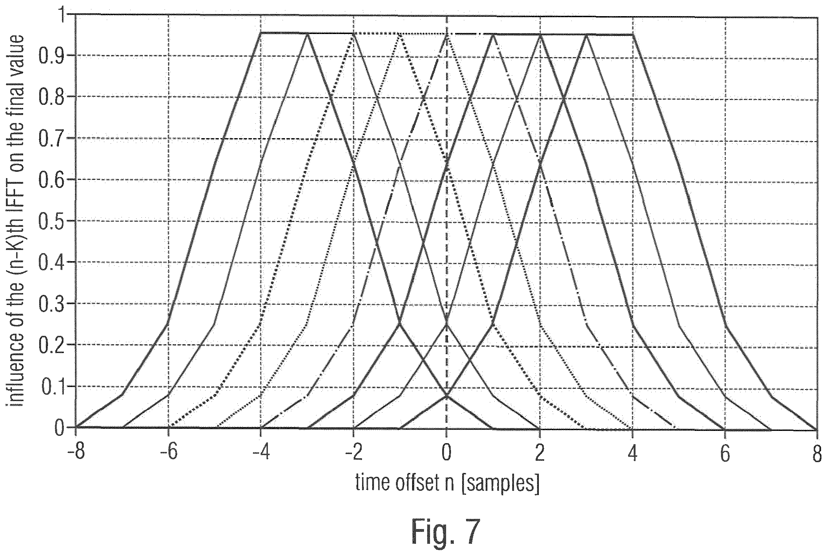

As multiple similar signals are added together, the effect of windowing on the data is implicitly removed. This is shown in Fig. 7 with the weights of an 8-channel FFT-PB, being added together.

Fig. 7 illustrates a reconstruction of eight channels for a system using a Hamming window according to an embodiment. In Fig. 7, the input x[n] = 1, for all values and the use of a Hamming window.

The full System reacts similar to a filter band containing a number of non-down-sampling Finite Impulse Response (FIR) filters. Through the use of the FFT, the reconstruction has an approximate fiat spectrum; therefore the output signal is optimally undistorted. Further, the FF1 allows simple scaling of the system.

In the following, a mathematical description is provided.

Given an input signal x[n], the m-th channel will have the value

$$x_r[n, m] = x[n - m]; \quad m = 0, 1, \ldots, (M - 1)$$

For the windowing function w[m], the function can be expressed after windowing as

$$x_w[n, m] = w[m] \cdot x_r[n, m] = w[m] \cdot x[n - m]$$

After the first DFT, each channel will have the form

$$X_{DFT}[n, m] = \sum_{k=0}^{M-1} x_w[n, k] \cdot e^{-2\pi i \cdot \frac{km}{M}} = \sum_{k=0}^{M-1} w[k] \cdot x[n - k] \cdot e^{-2\pi i \cdot \frac{km}{M}}$$

The data manipulation changes each input, depending on the goal of the system. This should be seen as a function that translates each input.

$$Y_{DFT}[n, m] = DM\{X_{DFT}[n, m]\} = DM\left\{\sum_{k=0}^{M-1} w[k] \cdot x[n - k] \cdot e^{-2\pi i \cdot \frac{km}{M}}\right\}$$

After the IFFT stage the m'th channel can be described as:

$$y[n, m] = \frac{1}{M} \sum_{l=0}^{M-1} Y_{DFT}[n, l] \cdot e^{2\pi i \cdot \frac{lm}{M}}$$

Through substitution it can be expressed as:

$$y[n, m] = \frac{1}{M} \sum_{l=0}^{M-1} \left( DM\left\{\sum_{k=0}^{M-1} w[k] \cdot x[n - k] \cdot e^{-2\pi i \cdot \frac{km}{M}}\right\}\right) \cdot e^{2\pi i \cdot \frac{lm}{M}}$$

Finally using the triangular delay and adding the signals together with the appropriate scaling

$$y_o[n] = \frac{1}{M} \sum_{m=0}^{M-1} y[n + M - 1 - m, m]$$

Through further substitution, the final simplified expression can be presented

$$y_o[n] = \frac{1}{M^2} \sum_{m=0}^{M-1} \sum_{l=0}^{M-1} \left( DM\left\{\sum_{k=0}^{M-1} w[k] \cdot x[n + M - 1 - m - k] \cdot e^{-2\pi i \cdot \frac{km}{M}}\right\}\right) \cdot e^{2\pi i \cdot \frac{lm}{M}}$$

Through the added redundancy (additional computational effort) of calculating the transformation for each sample offset, the reconstruction of the signal is smoothed out. In the case of removing an interference signal, the outputs are implicitly weighted; hence less distortion of the output is expected. This improves any mitigation method used. The ringing and phase discontinuity problems and limitation of FDAF algorithm therefore overcome through the proposed method. Further, FDAF has many issues when window-methods are used: these are overcome with the output being smoothed by the HDDM. Windowing can also be used to simply adapt the filter used.

As the HDDM separates the spectrum efficiently, no estimation or prediction is required for the data manipulation section; therefore it is less complex than adaptive methods and is guaranteed robust. This is in comparison the adaptive mitigation and equalization methods which use complex feedback loops.

The DFT is used as the method to separate the signals in frequency; no FIR filter design is required. The design and optimization of filters is time consuming, and should often be re-done for each new development. In the case of the HDDM direct frequency scaling can be used, hence complex design is circumvented.

The above concepts can be implemented highly parallelized; therefore, the implementation performance of ASIC and FPGA based systems can be exploited to achieve processing efficiency using parallelization.

Embodiments provide concepts that provide a very high time resolution (as high as the sampling rate is) while keeping the frequency resolution of a standard N-point DFT.

Some embodiments may, e.g., be realized by a high time resolution DFT (running DFT oversampled DFT). For example, no block wise processing is applied.

Some embodiments provide efficient concepts for reconstructing an oversampled signal that reduces PB effects such as ringing.

Potential applications may, e.g., be interference mitigation, especially for dynamic signals (both in time and frequency domain).

Some embodiments, may, e.g., provide a parallelized robust mitigation technique which does not required advanced filter design, tuning or adaption.

In some embodiments, shaping of the signal may, e.g., be conducted in addition to the interference.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software or at least partially in hardware or at least partially in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitory.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The methods described herein may be performed using a hardware apparatus, or using a computer, or using a combination of a hardware apparatus and a computer.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**Claims**

1. An apparatus for generating a reconstructed time-domain signal from an input time-domain signal, wherein the apparatus comprises:

    a transformation unit (110), a manipulation unit (120), and a reconstruction unit (130),
    wherein, in a first clock cycle, the transformation unit (110) is configured to transform a first plurality of time-domain samples of the input time-domain signal or derived from the input time-domain signal from a time domain to a frequency domain to obtain a first plurality of frequency-domain samples of a frequency-domain signal,
    wherein, in a second clock cycle, the transformation unit (110) is configured to transform a second plurality of the time-domain samples of the input time-domain signal or derived from the input time-domain signal from the time domain to the frequency domain to obtain a second plurality of frequency-domain samples of the frequency-domain signal, wherein the first plurality of time-domain samples and the second plurality of time-domain samples comprise one or more same time-domain samples of the input time-domain signal,
    wherein the manipulation unit (120) is configured to manipulate one or more frequency-domain samples of the first plurality of frequency-domain samples to obtain a first plurality of manipulated frequency samples, and
    wherein the manipulation unit (120) is configured to manipulate one or more frequency-domain samples of the second plurality of frequency-domain samples to obtain a second plurality of manipulated frequency samples, and
    wherein the reconstruction unit (130) is configured to generate the reconstructed time-domain signal depending on the first plurality of manipulated frequency samples and depending on the second plurality of manipulated frequency samples.

2. An apparatus according to claim 1,

    wherein the transformation unit (110) comprises a shift register (210) and a transform module (230),
    wherein the shift register (210) comprises a plurality of storage elements, wherein the transformation module is configured to store the first plurality of the time-domain samples within the plurality of storage elements of the shift register (210),
    wherein, in the first clock cycle, the transform module (230) is configured to transform the first plurality of the time-domain samples from the time domain to the frequency domain to obtain the first plurality of the frequency-domain samples,
    wherein, after transforming the first plurality of time-domain samples by the transform module (230), the shift register (210) is configured to shift each of the first plurality of time-domain samples in the shift register (210), so that one the first plurality of time-domain samples is moved out of the shift register (210), so that each other of the first plurality of time-domain samples is moved from its storage element to a neighbouring storage element, and so that another time-domain sample of the input time-domain signal or derived from the input time-domain signal, not comprised by the first plurality of time-domain samples, is stored in the storage element, wherein the time-domain samples being stored in the storage element after shifting form the second plurality of the time-domain samples, and
    wherein, in the second clock cycle, the transform module (230) is configured to transform the second plurality of the time-domain samples from the time domain to the frequency domain to obtain the second plurality of the frequency-domain samples of the frequency-domain signal.

3. An apparatus according to claim 1 or 2,

    wherein the transformation unit (110) comprises a window module (220),
    wherein before transforming the first plurality of time-domain samples derived from the input time-domain signal, the window module (220) is configured to apply a windowing function on the first plurality of time-domain samples of the input time-domain signal to obtain the first plurality of time-domain samples derived from the input time-domain signal,

wherein before transforming the second plurality of time-domain samples derived from the input time-domain signal, the window module (220) is configured to apply the windowing function on the second plurality of time-domain samples of the input time-domain signal to obtain the second plurality of time-domain samples derived from the input time-domain signal.

4. An apparatus according to one of the preceding claims,

wherein, in the first clock cycle, the transformation unit (110) is configured to transform the first plurality of time-domain samples of the input time-domain signal or derived from the input time-domain signal from the time domain to the frequency domain by conducting a Discrete Fourier Transform, and

wherein, in the second clock cycle, the transformation unit (110) is configured to transform the second plurality of time-domain samples of the input time-domain signal or derived from the input time-domain signal from the time domain to the frequency domain by conducting the Discrete Fourier Transform.

5. An apparatus according to one of claims 1 to 3,

wherein, in the first clock cycle, the transformation unit (110) is configured to transform the first plurality of time-domain samples of the input time-domain signal or derived from the input time-domain signal from the time domain to the frequency domain by conducting a Fast Fourier Transform, and

wherein, in the second clock cycle, the transformation unit (110) is configured to transform the second plurality of time-domain samples of the input time-domain signal or derived from the input time-domain signal from the time domain to the frequency domain by conducting the Fast Fourier Transform.

6. An apparatus according to one of the preceding claims,
wherein the manipulation unit (120) is configured to remove the one or more frequency-domain samples of the first plurality of frequency-domain samples from the first plurality of frequency-domain samples to obtain the first plurality of manipulated frequency samples, and wherein manipulation unit (120) is configured to remove the one or more frequency-domain samples of the second plurality of frequency-domain samples from the second plurality of frequency-domain samples to obtain the second plurality of manipulated frequency samples.

7. An apparatus according to one of the preceding claims,

wherein the manipulation unit (120) is configured to manipulate the first plurality of frequency-domain samples by filtering the first plurality of frequency-domain samples to obtain the first plurality of manipulated frequency samples, and

wherein the manipulation unit (120) is configured to manipulate the second plurality of frequency-domain samples by filtering the second plurality of frequency-domain samples to obtain the first plurality of manipulated frequency samples.

8. An apparatus according to one of the preceding claims,

wherein the manipulation unit (120) is configured to manipulate the first plurality of frequency-domain samples by spectrum shaping the first plurality of frequency-domain samples to obtain the first plurality of manipulated frequency samples, and

wherein the manipulation unit (120) is configured to manipulate the second plurality of frequency-domain samples by spectrum shaping the second plurality of frequency-domain samples to obtain the first plurality of manipulated frequency samples.

9. An apparatus according to one of the preceding claims,

wherein the reconstruction unit (130) comprises an inverse transform module (240) and a combination module (250),

wherein the inverse transform module (240) is configured to transform the first plurality of manipulated frequency samples from the frequency domain to the time domain to obtain a first plurality of manipulated time samples,

wherein the inverse transform module (240) is configured to transform second plurality of manipulated frequency samples from the frequency domain to the time domain to obtain a second plurality of manipulated time samples, and

wherein the combination module (250) is configured to combine the first plurality of manipulated time samples and the second plurality of manipulated time samples to obtain a plurality of time-domain samples of the reconstructed time-domain signal.

10. An apparatus according to claim 9,

wherein the inverse transform module (240) is configured to transform the first plurality of manipulated frequency samples from the frequency domain to the time domain by conducting an Inverse Discrete Fourier Transform, and wherein the inverse transform module (240) is configured to transform the second plurality of manipulated frequency samples from the frequency domain to the time domain by conducting the Inverse Discrete Fourier Transform.

11. An apparatus according to claim 9,

wherein the inverse transform module (240) is configured to transform the first plurality of manipulated frequency samples from the frequency domain to the time domain by conducting an Inverse Fast Fourier Transform, and wherein the inverse transform module (240) is configured to transform the second plurality of manipulated frequency samples from the frequency domain to the time domain by conducting the Inverse Fast Fourier Transform.

12. An apparatus according to one of claims 9 to 11,

• wherein the combination module (250) is configured to apply a triangular delay on the first plurality of manipulated time samples and to apply a triangular delay on the second plurality of manipulated time samples and to combine the first plurality of manipulated time samples and the second plurality of manipulated time samples to obtain the plurality of time-domain samples of the reconstructed time-domain signal.

13. An apparatus according to one of claims 9 to 12,

wherein the combination module (250) is configured to scale the first plurality of manipulated time samples to obtain a first plurality of scaled time samples,
wherein the combination module (250) is configured to scale the second plurality of manipulated time samples to obtain a second plurality of scaled time samples, and
wherein the combination module (250) is configured to add the first plurality of scaled time samples and the second plurality of scaled time samples to obtain the plurality of time-domain samples of the reconstructed time-domain signal.

14. A method for generating a reconstructed time-domain signal from an input time-domain signal, wherein the method comprises:

transforming, in a first clock cycle, a first plurality of time-domain samples of the input time-domain signal or derived from the input time-domain signal from a time domain to a frequency domain to obtain a first plurality of frequency-domain samples of a frequency-domain signal,
transforming, in a second clock cycle, a second plurality of the time-domain samples of the input time-domain signal or derived from the input time-domain signal from the time domain to the frequency domain to obtain a second plurality of frequency-domain samples of the frequency-domain signal, wherein the first plurality of time-domain samples and the second plurality of time-domain samples comprise one or more same time-domain samples of the input time-domain signal,
manipulating one or more frequency-domain samples of the first plurality of frequency-domain samples to obtain a first plurality of manipulated frequency samples, and manipulating one or more frequency-domain samples of the second plurality of frequency-domain samples to obtain a second plurality of manipulated frequency samples, and
generating the reconstructed time-domain signal depending on the first plurality of manipulated frequency samples and depending on the second plurality of manipulated frequency samples.

15. A computer program for implementing the method of claim 14 when being executed on a computer or signal processor.

**Patentansprüche**

1. Eine Vorrichtung zum Erzeugen eines rekonstruierten Zeitbereichssignals von einem Eingangszeitbereichssignal, wobei die Vorrichtung folgende Merkmale aufweist:

   eine Transformationseinheit (110), eine Manipulationseinheit (120) und eine Rekonstruktionseinheit (130),
   wobei in einem ersten Taktzyklus die Transformationseinheit (110) konfiguriert ist, eine erste Mehrzahl von Zeitbereichsabtastwerten des Eingangszeitbereichssignals oder abgleitet von dem Eingangszeitbereichssignal von einem Zeitbereich in einen Frequenzbereich zu transformieren, um eine erste Mehrzahl von Frequenzbereichsabtastwerten eines Frequenzbereichssignals zu erhalten,
   wobei in einem zweiten Taktzyklus die Transformationseinheit (110) konfiguriert ist, eine zweite Mehrzahl der Zeitbereichsabtastwerte des Eingangszeitbereichssignals oder abgeleitet von dem Eingangszeitbereichssignal von dem Zeitbereich in den Frequenzbereich zu transformieren, um eine zweite Mehrzahl von Frequenzbereichsabtastwerten des Frequenzbereichssignals zu erhalten, wobei die erste Mehrzahl von Zeitbereichsabtastwerten und die zweite Mehrzahl von Zeitbereichsabtastwerten eine oder mehrere gleiche Zeitbereichsabtastwerte des Eingangszeitbereichssignals aufweisen,
   wobei die Manipulationseinheit (120) konfiguriert ist, einen oder mehrere Frequenzbereichsabtastwerte der ersten Mehrzahl von Frequenzbereichsabtastwerten zu manipulieren, um eine erste Mehrzahl von manipulierten Frequenzabtastwerten zu erhalten, und wobei die Manipulationseinheit (120) konfiguriert ist, einen oder mehrere Frequenzbereichsabtastwerte der zweiten Mehrzahl von Frequenzbereichsabtastwerten zu manipulieren, um eine zweite Mehrzahl von manipulierten Frequenzabtastwerten zu erhalten und
   wobei die Rekonstruktionseinheit (130) konfiguriert ist, das rekonstruierte Zeitbereichssignal in Abhängigkeit von der ersten Mehrzahl von manipulierten Frequenzabtastwerten und in Abhängigkeit von der zweiten Mehrzahl von manipulierten Frequenzabtastwerten zu erzeugen.

2. Eine Vorrichtung gemäß Anspruch 1,

   wobei die Transformationseinheit (110) ein Schieberegister (210) und ein Transformationsmodul (230) aufweist,
   wobei das Schieberegister (210) eine Mehrzahl von Speicherelementen umfasst, wobei das Transformationsmodul konfiguriert ist, die erste Mehrzahl von Zeitbereichsabtastwerten innerhalb der Mehrzahl von Speicherelementen des Schieberegisters (210) zu speichern,
   wobei in dem ersten Taktzyklus das Transformationsmodul (230) konfiguriert ist, die erste Mehrzahl von Zeitbereichsabtastwerten von dem Zeitbereich in den Frequenzbereich zu transformieren, um die erste Mehrzahl von Frequenzbereichsabtastwerten zu erhalten,
   wobei das Schieberegister (210) nach dem Transformieren der ersten Mehrzahl von Zeitbereichsabtastwerten durch das Transformationsmodul (230) konfiguriert ist, jeden der ersten Mehrzahl von Zeitbereichsabtastwerten in dem Schieberegister (210) zu verschieben, so dass einer der ersten Mehrzahl von Zeitbereichsabtastwerten aus dem Schieberegister (210) herausbewegt wird, so dass jeder andere der ersten Mehrzahl von Zeitbereichsabtastwerten von seinem Speicherelement zu einem benachbarten Speicherelement bewegt wird, und so dass ein anderer Zeitbereichsabtastwert des Eingangszeitbereichssignals oder abgeleitet von dem Eingangszeitbereichssignal, der nicht in der ersten Mehrzahl von Zeitbereichsabtastwerten enthalten ist, in dem Speicherelement gespeichert wird, wobei die Zeitbereichsabtastwerte, die nach dem Verschieben in dem Speicherelement gespeichert werden, die zweite Mehrzahl von Zeitbereichsabtastwerten bilden, und
   wobei in dem zweiten Taktzyklus das Transformationsmodul (230) konfiguriert ist, die zweite Mehrzahl von Zeitbereichsabtastwerten von dem Zeitbereich in den Frequenzbereich zu transformieren, um die zweite Mehrzahl der Frequenzabtastwerte des Frequenzbereichssignals zu erhalten.

3. Eine Vorrichtung gemäß Anspruch 1 oder 2,

   wobei die Transformationseinheit (110) ein Fenstermodul (220) aufweist,
   wobei das Fenstermodul (220) konfiguriert ist, vor dem Transformieren der ersten Mehrzahl von Zeitbereichsabtastwerten, die von dem Eingangszeitbereichssignal abgeleitet sind, eine Fensterfunktion an die erste Mehrzahl von Zeitbereichsabtastwerten des Eingangszeitbereichssignals anzulegen, um die erste Mehrzahl von Zeitbereichsabtastwerten zu erhalten, die von dem Eingangszeitbereichssignal abgeleitet sind,
   wobei das Fenstermodul (220) konfiguriert ist, vor dem Transformieren der zweiten Mehrzahl von Zeitbereichsabtastwerten, die von dem Eingangszeitbereichssignal abgeleitet sind, die Fensterfunktion an die zweite Mehrzahl von Zeitbereichsabtastwerten des Eingangszeitbereichssignals anzulegen, um die zweite Mehrzahl von Zeitbereichsabtastwerten zu erhalten, die von dem Eingangszeitbereichssignal abgeleitet sind.

**4.** Eine Vorrichtung gemäß einem der vorhergehenden Ansprüche,

wobei in dem ersten Taktzyklus die Transformationseinheit (110) konfiguriert ist, die erste Mehrzahl von Zeitbereichsabtastwerten des Eingangszeitbereichssignals oder abgeleitet von dem Eingangszeitbereichssignal von dem Zeitbereich in den Frequenzbereich zu transformieren, indem dieselbe eine Diskrete Fourier-Transformation durchführt, und
wobei in dem zweiten Taktzyklus die Transformationseinheit (110) konfiguriert ist, die zweite Mehrzahl von Zeitbereichsabtastwerten des Eingangszeitbereichssignals oder abgeleitet von dem Eingangszeitbereichssignal von dem Zeitbereich in den Frequenzbereich zu transformieren, indem dieselbe die Diskrete Fourier-Transformation durchführt.

**5.** Eine Vorrichtung gemäß einem der Ansprüche 1 bis 3,

wobei in dem ersten Taktzyklus die Transformationseinheit (110) konfiguriert ist, die erste Mehrzahl von Zeitbereichsabtastwerten des Eingangszeitbereichssignals oder abgeleitet von dem Eingangszeitbereichssignal von dem Zeitbereich in den Frequenzbereich zu transformieren, indem dieselbe eine schnelle Fourier-Transformation durchführt, und
wobei in dem zweiten Taktzyklus die Transformationseinheit (110) konfiguriert ist, die zweite Mehrzahl von Zeitbereichsabtastwerten des Eingangszeitbereichssignals oder abgeleitet von dem Eingangszeitbereichssignal von dem Zeitbereich in den Frequenzbereich zu transformieren, indem dieselbe die schnelle Fourier-Transformation durchführt.

**6.** Eine Vorrichtung gemäß einem der vorhergehenden Ansprüche,
wobei die Manipulationseinheit (120) konfiguriert ist, den einen oder die mehreren Frequenzbereichsabtastwerte der ersten Mehrzahl von Frequenzbereichsabtastwerten aus der ersten Mehrzahl von Frequenzbereichsabtastwerten zu entfernen, um die erste Mehrzahl von manipulierten Frequenzabtastwerten zu erhalten, und wobei die Manipulationseinheit (120) konfiguriert ist, den einen oder die mehreren Frequenzbereichsabtastwerte der zweiten Mehrzahl von Frequenzbereichsabtastwerten aus der zweiten Mehrzahl von Frequenzbereichsabtastwerten zu entfernen, um die zweite Mehrzahl von manipulierten Frequenzabtastwerten zu erhalten.

**7.** Eine Vorrichtung gemäß einem der vorhergehenden Ansprüche,

wobei die Manipulationseinheit (120) konfiguriert ist, die erste Mehrzahl von Frequenzbereichsabtastwerten durch Filtern der ersten Mehrzahl von Frequenzbereichsabtastwerten zu manipulieren, um die erste Mehrzahl von manipulierten Frequenzabtastwerten zu erhalten, und
wobei die Manipulationseinheit (120) konfiguriert ist, die zweite Mehrzahl von Frequenzbereichsabtastwerten durch Filtern der zweiten Mehrzahl von Frequenzbereichsabtastwerten zu manipulieren, um die erste Mehrzahl von manipulierten Frequenzabtastwerten zu erhalten.

**8.** Eine Vorrichtung gemäß einem der vorhergehenden Ansprüche,

wobei die Manipulationseinheit (120) konfiguriert ist, die erste Mehrzahl von Frequenzbereichsabtastwerten durch Spektrumformen der ersten Mehrzahl von Frequenzbereichsabtastwerten zu manipulieren, um die erste Mehrzahl von manipulierten Frequenzabtastwerten zu erhalten und,
wobei die Manipulationseinheit (120) konfiguriert ist, die zweite Mehrzahl von Frequenzbereichsabtastwerten durch Spektrumformen der zweiten Mehrzahl von Frequenzbereichsabtastwerten zu manipulieren, um die erste Mehrzahl von manipulierten Frequenzabtastwerten zu erhalten.

**9.** Eine Vorrichtung gemäß einem der vorhergehenden Ansprüche,

wobei die Rekonstruktionseinheit (130) ein Inverse-Transformation-Modul (240) und ein Kombinationsmodul (250) aufweist,
wobei das Inverse-Transformation-Modul (240) konfiguriert ist, die erste Mehrzahl von manipulierten Frequenzabtastwerten von dem Frequenzbereich in den Zeitbereich zu transformieren, um eine erste Mehrzahl von manipulierten Zeitabtastwerten zu erhalten,
wobei das Inverse-Transformation-Modul (240) konfiguriert ist, eine zweite Mehrzahl von manipulierten Frequenzabtastwerten von dem Frequenzbereich in den Zeitbereich zu transformieren, um eine zweite Mehrzahl von manipulierten Zeitabtastwerten zu erhalten und

wobei das Kombinationsmodul (250) konfiguriert ist, die erste Mehrzahl von manipulierten Zeitabtastwerten und die zweite Mehrzahl von manipulierten Zeitabtastwerten zu kombinieren, um eine Mehrzahl von Zeitbereichsabtastwerten des rekonstruierten Zeitbereichssignals zu erhalten.

**10.** Eine Vorrichtung gemäß Anspruch 9,

wobei das inverse-Transformation-Modul (240) konfiguriert ist, die erste Mehrzahl von manipulierten Frequenzabtastwerten von dem Frequenzbereich in den Zeitbereich zu transformieren, durch Durchführen einer inversen diskreten Fourier-Transformation und
wobei das Inverse-Transformation-Modul (240) konfiguriert ist, die zweite Mehrzahl von manipulierten Frequenzabtastwerten von dem Frequenzbereich in den Zeitbereich zu transformieren, durch Durchführen der inversen diskreten Fourier-Transformation.

**11.** Eine Vorrichtung gemäß Anspruch 9,

wobei das Inverse-Transformation-Modul (240) konfiguriert ist, die erste Mehrzahl von manipulierten Frequenzabtastwerten von dem Frequenzbereich in den Zeitbereich zu transformieren, durch Durchführen einer inversen schnellen Fourier-Transformation und
wobei das Inverse-Transformation-Moduls (240) konfiguriert ist, die zweite Mehrzahl von manipulierten Frequenzabtastwerten von dem Frequenzbereich in den Zeitbereich zu transformieren, durch Durchführen der inversen schnellen Fourier-Transformation.

**12.** Eine Vorrichtung gemäß einem der Ansprüche 9 bis 11,
wobei das Kombinationsmodul (250) konfiguriert ist, eine Dreiecksverzögerung an die erste Mehrzahl von manipulierten Zeitabtastwerten anzulegen und eine Dreiecksverzögerung an die zweite Mehrzahl von manipulierten Zeitabtastwerten anzulegen, und die erste Mehrzahl von manipulierten Zeitabtastwerten und die zweite Mehrzahl von manipulierten Zeitabtastwerten zu kombinieren, um die Mehrzahl von Zeitbereichsabtastwerten des rekonstruierten Zeitbereichssignals zu erhalten.

**13.** Eine Vorrichtung gemäß einem der Ansprüche 9 bis 12,

wobei das Kombinationsmodul (250) konfiguriert ist, die erste Mehrzahl von manipulierten Zeitabtastwerten zu skalieren, um eine erste Mehrzahl von skalierten Zeitabtastwerten zu erhalten,
wobei das Kombinationsmodul (250) konfiguriert ist, die zweite Mehrzahl von manipulierten Zeitabtastwerten zu skalieren, um eine zweite Mehrzahl von skalierten Zeitabtastwerten zu erhalten und
wobei das Kombinationsmodul (250) konfiguriert ist, die erste Mehrzahl von skalierten Zeitabtastwerten und die zweite Mehrzahl von skalierten Zeitabtastwerten zu addieren, um die Mehrzahl von Zeitbereichsabtastwerten des rekonstruierten Zeitbereichssignals zu erhalten.

**14.** Ein Verfahren zum Erzeugen eines rekonstruierten Zeitbereichssignals von einem Eingangszeitbereichssignal, wobei das Verfahren folgende Schritte aufweist:

Transformieren, in einem ersten Taktzyklus, einer ersten Mehrzahl von Zeitbereichsabtastwerten des Eingangszeitbereichssignals oder abgleitet von dem Eingangszeitbereichssignal von einem Zeitbereich in einen Frequenzbereich, um eine erste Mehrzahl von Frequenzbereichsabtastwerten eines Frequenzbereichssignals zu erhalten,
Transformieren, in einem zweiten Taktzyklus, einer zweiten Mehrzahl der Zeitbereichsabtastwerte des Eingangszeitbereichssignals oder abgeleitet von dem Eingangszeitbereichssignal von dem Zeitbereich in den Frequenzbereich, um eine zweite Mehrzahl von Frequenzbereichsabtastwerten des Frequenzbereichssignals zu erhalten, wobei die erste Mehrzahl von Zeitbereichsabtastwerten und die zweite Mehrzahl von Zeitbereichsabtastwerten einen oder mehrere gleiche Zeitbereichsabtastwerte des Eingangszeitbereichssignals aufweisen,
Manipulieren eines oder mehrerer Frequenzbereichsabtastwerte der ersten Mehrzahl von Frequenzbereichsabtastwerten, um eine erste Mehrzahl von manipulierten Frequenzabtastwerten zu erhalten, und Manipulieren eines oder mehrerer Frequenzbereichsabtastwerte der zweiten Mehrzahl von Frequenzbereichsabtastwerten, um eine zweite Mehrzahl von manipulierten Frequenzabtastwerten zu erhalten und
Erzeugen des rekonstruierten Zeitbereichssignals in Abhängigkeit von der ersten Mehrzahl von manipulierten Frequenzabtastwerten und in Abhängigkeit von der zweiten Mehrzahl von manipulierten Frequenzabtastwerten.

15. Ein Computerprogramm zum Implementieren des Verfahrens gemäß Anspruch 14, wenn dasselbe auf einem Computer oder Signalprozessor ausgeführt wird.


**Revendications**

1. Appareil pour générer un signal dans le domaine temporel reconstruit à partir d'un signal d'entrée dans le domaine temporel, dans lequel l'appareil comprend:

   une unité de transformation (110), une unité de manipulation (120) et une unité de reconstruction (130), dans lequel, dans un premier cycle d'horloge, l'unité de transformation (110) est configurée pour transformer une première pluralité d'échantillons dans le domaine temporel du signal d'entrée dans le domaine temporel, ou dérivés du signal d'entrée dans le domaine temporel, d'un domaine temporel à un domaine de la fréquence pour obtenir une première pluralité d'échantillons dans le domaine de la fréquence d'un signal dans le domaine de la fréquence,
   dans lequel, dans un deuxième cycle d'horloge, l'unité de transformation (110) est configurée pour transformer une deuxième pluralité d'échantillons dans le domaine temporel du signal d'entrée dans le domaine temporel, ou dérivés du signal d'entrée dans le domaine temporel, du domaine temporel au domaine de la fréquence pour obtenir une deuxième pluralité d'échantillons dans le domaine de la fréquence du signal dans le domaine de la fréquence, dans lequel la première pluralité d'échantillons dans le domaine temporel et la deuxième pluralité d'échantillons dans le domaine temporel comprennent un ou plusieurs échantillons dans le domaine temporel identiques du signal d'entrée dans le domaine temporel,
   dans lequel l'unité de manipulation (120) est configurée pour manipuler un ou plusieurs échantillons dans le domaine de la fréquence de la première pluralité d'échantillons dans le domaine de la fréquence pour obtenir une première pluralité d'échantillons dans le domaine de la fréquence manipulés, et dans lequel l'unité de manipulation (120) est configurée pour manipuler un ou plusieurs échantillons dans le domaine de la fréquence de la deuxième pluralité d'échantillons dans le domaine de la fréquence pour obtenir une deuxième pluralité d'échantillons dans le domaine de la fréquence manipulés, et
   dans lequel l'unité de reconstruction (130) est configurée pour générer le signal dans le domaine temporel reconstruit en fonction de la première pluralité d'échantillons dans le domaine de la fréquence manipulés et en fonction de la deuxième pluralité d'échantillons dans le domaine de la fréquence manipulés.

2. Appareil selon la revendication 1,

   dans lequel l'unité de transformation (110) comprend un registre à décalage (210) et un module de transformée (230),
   dans lequel le registre à décalage (210) comprend une pluralité d'éléments de mémorisation, dans lequel le module de transformation est configuré pour mémoriser la première pluralité des échantillons dans le domaine temporel dans la pluralité d'éléments de mémorisation du registre à décalage (210),
   dans lequel, dans le premier cycle d'horloge, le module de transformée (230) est configuré pour transformer la première pluralité des échantillons dans le domaine temporel du domaine temporel au domaine de la fréquence pour obtenir la première pluralité des échantillons dans le domaine de la fréquence,
   dans lequel, après transformation de la première pluralité d'échantillons dans le domaine temporel par le module de transformée (230), le registre à décalage (210) est configuré pour décaler chacun de la première pluralité d'échantillons dans le domaine temporel dans le registre à décalage (210), de sorte qu'un de la première pluralité d'échantillons dans le domaine temporel soit déplacé hors du registre à décalage (210), de sorte que chaque autre de la première pluralité d'échantillons dans le domaine temporel soit déplacé de son élément de mémorisation à un élément de mémorisation voisin, et de sorte qu'un autre échantillon dans le domaine temporel du signal d'entrée dans le domaine temporel, ou dérivé du signal d'entrée dans le domaine temporel, non compris dans la première pluralité d'échantillons dans le domaine temporel, soit mémorisé dans l'élément de mémorisation, dans lequel les échantillons dans le domaine temporel sont mémorisés dans l'élément de mémorisation après le décalage de la deuxième pluralité des échantillons dans le domaine temporel, et
   dans lequel, dans le deuxième cycle d'horloge, le module de transformée (230) est configuré pour transformer la deuxième pluralité des échantillons dans le domaine temporel du domaine temporel au domaine de la fréquence pour obtenir la deuxième pluralité des échantillons dans le domaine de la fréquence du signal dans le domaine de la fréquence.

3. Appareil selon la revendication 1 ou 2,

dans lequel l'unité de transformation (110) comprend un module de fenêtre (220),

dans lequel, avant de transformer la première pluralité d'échantillons dans le domaine temporel dérivés du signal d'entrée dans le domaine temporel, le module de fenêtre (220) est configuré pour appliquer une fonction de division en fenêtres à la première pluralité d'échantillons dans le domaine temporel du signal d'entrée dans le domaine temporel pour obtenir la première pluralité d'échantillons dans le domaine temporel dérivés du signal d'entrée dans le domaine temporel,

dans lequel, avant de transformer la deuxième pluralité d'échantillons dans le domaine temporel dérivés du signal d'entrée dans le domaine temporel, le module de fenêtre (220) est configuré pour appliquer la fonction de division en fenêtres à la deuxième pluralité d'échantillons dans le domaine temporel du signal d'entrée dans le domaine temporel pour obtenir la deuxième pluralité d'échantillons dans le domaine temporel dérivés du signal d'entrée dans le domaine temporel.

4. Appareil selon l'une des revendications précédentes,

   dans lequel, dans le premier cycle d'horloge, l'unité de transformation (110) est configurée pour transformer la première pluralité d'échantillons dans le domaine temporel du signal d'entrée dans le domaine temporel, ou dérivés du signal d'entrée dans le domaine temporel, du domaine temporel au domaine de la fréquence en réalisant une Transformée de Fourier Discrète, et

   dans lequel, dans le deuxième cycle d'horloge, l'unité de transformation (110) est configurée pour transformer la deuxième pluralité d'échantillons dans le domaine temporel du signal d'entrée dans le domaine temporel, ou dérivés du signal d'entrée dans le domaine temporel, du domaine temporel au domaine de la fréquence en réalisant la Transformée de Fourier Discrète.

5. Appareil selon l'une des revendications 1 à 3,

   dans lequel, dans le premier cycle d'horloge, l'unité de transformation (110) est configurée pour transformer la première pluralité d'échantillons dans le domaine temporel du signal d'entrée dans le domaine temporel, ou dérivés du signal d'entrée dans le domaine temporel, du domaine temporel au domaine de la fréquence en effectuant une Transformée de Fourier Rapide, et

   dans lequel, dans le deuxième cycle d'horloge, l'unité de transformation (110) est configurée pour transformer la deuxième pluralité d'échantillons dans le domaine temporel du signal d'entrée dans le domaine temporel, ou dérivés du signal d'entrée dans le domaine temporel, du domaine temporel au domaine de la fréquence en réalisant la Transformée de Fourier Rapide.

6. Appareil selon l'une des revendications précédentes,
   dans lequel l'unité de manipulation (120) est configurée pour éliminer les un ou plusieurs échantillons dans le domaine de la fréquence de la première pluralité d'échantillons dans le domaine de la fréquence de la première pluralité d'échantillons dans le domaine de la fréquence pour obtenir la première pluralité d'échantillons dans le domaine de la fréquence manipulés, et dans lequel l'unité de manipulation (120) est configurée pour éliminer les un ou plusieurs échantillons dans le domaine de la fréquence de la deuxième pluralité d'échantillons dans le domaine de la fréquence de la deuxième pluralité d'échantillons dans le domaine de la fréquence pour obtenir la deuxième pluralité d'échantillons dans le domaine de la fréquence manipulés.

7. Appareil selon l'une des revendications précédentes,

   dans lequel l'unité de manipulation (120) est configurée pour manipuler la première pluralité d'échantillons dans le domaine de la fréquence en filtrant la première pluralité d'échantillons dans le domaine de la fréquence pour obtenir la première pluralité d'échantillons dans le domaine de la fréquence manipulés, et

   dans lequel l'unité de manipulation (120) est configurée pour manipuler la deuxième pluralité d'échantillons dans le domaine de la fréquence en filtrant la deuxième pluralité d'échantillons dans le domaine de la fréquence pour obtenir la première pluralité d'échantillons dans le domaine de la fréquence manipulés.

8. Appareil selon l'une des revendications précédentes,

   dans lequel l'unité de manipulation (120) est configurée pour manipuler la première pluralité d'échantillons dans le domaine de la fréquence en mettant en forme le spectre de la première pluralité d'échantillons dans le domaine de la fréquence pour obtenir la première pluralité d'échantillons dans le domaine de la fréquence manipulés, et dans lequel l'unité de manipulation (120) est configurée pour manipuler la deuxième pluralité d'échantillons dans le domaine de la fréquence en mettant en forme le spectre de la deuxième pluralité d'échantillons dans le domaine de la fréquence pour obtenir la première pluralité d'échantillons dans le domaine de la fréquence manipulés.

9. Appareil selon l'une des revendications précédentes,

dans lequel l'unité de reconstruction (130) comprend un module de transformée inverse (240) et un module de combinaison (250),

dans lequel le module de transformée inverse (240) est configuré pour transformer la première pluralité d'échantillons dans le domaine de la fréquence manipulés du domaine de la fréquence au domaine temporel pour obtenir une première pluralité d'échantillons dans le domaine temporel manipulés,

dans lequel le module de transformée inverse (240) est configuré pour transformer une deuxième pluralité d'échantillons dans le domaine de la fréquence manipulés du domaine de la fréquence au domaine temporel pour obtenir une deuxième pluralité d'échantillons dans le domaine temporel manipulés, et

dans lequel le module de combinaison (250) est configuré pour combiner la première pluralité d'échantillons dans le domaine temporel manipulés et la deuxième pluralité d'échantillons dans le domaine temporel manipulés pour obtenir une pluralité d'échantillons dans le domaine temporel du signal dans le domaine temporel reconstruit.

10. Appareil selon la revendication 9,

dans lequel le module de transformée inverse (240) est configuré pour transformer la première pluralité d'échantillons dans le domaine de la fréquence manipulés du domaine de la fréquence au domaine temporel en réalisant une Transformée de Fourier Discrète Inverse, et

dans lequel le module de transformée inverse (240) est configuré pour transformer la deuxième pluralité d'échantillons dans le domaine de la fréquence manipulés du domaine de la fréquence au domaine temporel en réalisant la Transformée de Fourier Discrète Inverse.

11. Appareil selon la revendication 9,

dans lequel le module de transformée inverse (240) est configuré pour transformer la première pluralité d'échantillons dans le domaine de la fréquence manipulés du domaine de la fréquence au domaine temporel en réalisant une Transformée de Fourier Rapide Inverse, et

dans lequel le module de transformée inverse (240) est configuré pour transformer la deuxième pluralité d'échantillons dans le domaine de la fréquence manipulés du domaine de la fréquence au domaine temporel en réalisant la Transformée de Fourier Rapide Inverse.

12. Appareil selon l'une des revendications 9 à 11,

• dans lequel le module de combinaison (250) est configuré pour appliquer un retard triangulaire à la première pluralité d'échantillons dans le domaine temporel manipulés et pour appliquer un retard triangulaire à la deuxième pluralité d'échantillons dans le domaine temporel manipulés et pour combiner la première pluralité d'échantillons dans le domaine temporel manipulés et la deuxième pluralité d'échantillons dans le domaine temporel manipulés pour obtenir la pluralité d'échantillons dans le domaine temporel du signal dans le domaine temporel reconstruit.

13. Appareil selon l'une des revendications 9 à 12,

dans lequel le module de combinaison (250) est configuré pour mettre à échelle la première pluralité d'échantillons dans le domaine temporel manipulés pour obtenir une première pluralité d'échantillons dans le domaine temporel mis à échelle,

dans lequel le module de combinaison (250) est configuré pour mettre à échelle la deuxième pluralité d'échantillons dans le domaine temporel manipulés pour obtenir une deuxième pluralité d'échantillons dans le domaine temporel mis à échelle, et

dans lequel le module de combinaison (250) est configuré pour additionner la première pluralité d'échantillons dans le domaine temporel mis à échelle et la deuxième pluralité d'échantillons dans le domaine temporel mis à échelle pour obtenir la pluralité d'échantillons dans le domaine temporel du signal dans le domaine temporel reconstruit.

**14.** Procédé pour générer un signal dans le domaine temporel reconstruit à partir d'un signal d'entrée dans le domaine temporel, dans lequel le procédé comprend le fait de:

transformer, dans un premier cycle d'horloge, une première pluralité d'échantillons dans le domaine temporel du signal d'entrée dans le domaine temporel, ou dérivés du signal d'entrée dans le domaine temporel, d'un domaine temporel à un domaine de la fréquence pour obtenir une première pluralité d'échantillons dans le domaine de la fréquence d'un signal dans le domaine de la fréquence,

transformer, dans un deuxième cycle d'horloge, une deuxième pluralité d'échantillons dans le domaine temporel du signal d'entrée dans le domaine temporel, ou dérivés du signal d'entrée dans le domaine temporel, du domaine temporel au domaine de la fréquence pour obtenir une deuxième pluralité d'échantillons dans le domaine de la fréquence du signal dans le domaine de la fréquence, dans lequel la première pluralité d'échantillons dans le domaine temporel et la deuxième pluralité d'échantillons dans le domaine temporel comprennent un ou plusieurs échantillons dans le domaine temporel identiques du signal d'entrée dans le domaine temporel,

manipuler un ou plusieurs échantillons dans le domaine de la fréquence de la première pluralité d'échantillons dans le domaine de la fréquence pour obtenir une première pluralité d'échantillons dans le domaine de la fréquence manipulés, et manipuler un ou plusieurs échantillons dans le domaine de la fréquence de la deuxième pluralité d'échantillons dans le domaine de la fréquence pour obtenir une deuxième pluralité d'échantillons dans le domaine de la fréquence manipulés, et

générer le signal dans le domaine temporel reconstruit en fonction de la première pluralité d'échantillons dans le domaine de la fréquence manipulés et en fonction de la deuxième pluralité d'échantillons dans le domaine de la fréquence manipulés.

**15.** Programme d'ordinateur pour mettre en oeuvre le procédé selon la revendication 14 lorsqu'il est exécuté sur un ordinateur ou un processeur de signal.

input time-domain signal → [110 transformation Unit] → frequency domain signal → [120 manipulation Unit] → manipulated frequency samples → [130 reconstruction Unit] → reconstructed time-domain signal

Fig. 1

Fig. 2

Fig. 3

Fig. 4

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20040048090 A
- US 2002051433 A
- US 2009239472 A
- US 2009081980 A
- CN 1463104 A
- US 2006195279 A
- US 2003140771 A
- US 2002094044 A
- US 2013208838 A
- CN 102147429 A
- US 2012321024 A
- US 2006029142 A
- US 6097820 A